# EUROPÄISCHE PATENTSCHRIFT

(11) **EP 0 553 671 B1**
(45) Veröffentlichungstag und Bekanntmachung des Hinweises auf die Patenterteilung: **02.11.1995**
(21) Anmeldenummer: 93100647.2
(22) Anmeldetag: 18.01.1993
(51) Int. Cl.: H05K 3/42, C25D 5/56

(54) **Verfahren zur Durchkontaktierung von zweilagigen Leiterplatten und Multilayern**
Process for making through hole connections in double layered circuit boards and multilayers
Procédé pour établir des connexions à trou traversant dans des panneaux à circuit à deux couches et multicouches

(30) Priorität: 29.01.1992 DE 4202337
(43) Veröffentlichungstag der Anmeldung: 04.08.1993
(73) Patentinhaber: BAYER AG, 51368 Leverkusen (DE)
(72) Erfinder: Jonas, Friedrich, Dr., W-5100 Aachen (DE); Wolf, Gerhard-Dieter, Dr., W-4047 Dormagen 5 (DE)

(56) Entgegenhaltungen:
- WO-A-89/08375
- WO-A-91/08324
- US-A- 5 035 926

## Beschreibung

Die Erfindung betrifft ein Verfahren zur Herstellung von durchkontaktierten zweilagigen Leiterplatten und Multilayern unter Verwendung von Polythiophenen als leitfähige Ausrüstung der Bohrlöcher für die direkte galvanische Durchkontaktierung.

Verfahren zur Durchkontaktierung von beidseitig kupferkaschierten Leiterplatten, z.B. auf Basis glasfaserverstärkter Epoxidhaze sind bekannt (vgl. Herrmann, Handbuch der Leiterplattentechnik, Eugen G. Leuze Verlag, Saulgau). Im allgemeinen werden die Wände der Bohrlöcher in den Leiterplatten nach an sich bekannten Verfahren in chemischen Metallisierungsbädern mit Metallen, vorzugsweise Kupfer beschichtet und so elektrisch leitfähige Verbindungen zwischen der Ober- und Unterseite der Leiterplatten hergestellt. In der Regel werden diese leitfähigen Verbindungen durch galvanische Abscheidung von Kupfer aus Kupferbädern verstärkt (Durchsteiger).

In der letzten Zeit haben Verfahren an Bedeutung gewonnen, in denen auf den Einsatz chemischer Kupferbäder verzichtet wird und in denen Kupfer direkt galvanisch auf den Bohrlochwandungen von Leiterplatten abgeschieden wird. Hierzu ist es erforderlich, die Bohrlochwandungen vor der galvanischen Abscheidung des Kupfers mit einer elektrisch leitfähigen Beschichtung auszurüsten. Diese Beschichtung muß gleichmäßig aufgetragen werden können und außerdem genügend elektrisch leitend sein, um als Basis für eine einwandfreie flächendeckende galvanische Kupferabscheidung (Durchkontaktierung) zu dienen.

In der DE-PS 3 806 884 und der DE-OS 3 927 440 wird beschrieben Polypyrrol als leitfähige Beschichtung im Bohrloch für die Abscheidung von Kupfer zu verwenden. Die Herstellungsverfahren erfordern folgende Schritte:
1. Herstellung der Bohrungen in den mit Kupfer kaschierten Platten (Basismaterialien)
2. Oxidative Vorbehandlung der Bohrlöcher, z.B. mit alkalischer Kaliumpermanganatlösung
3. Spülen mit Wasser
4 Behandlung mit einer Pyrrollösung
5 Behandlung mit einer wäßrigen Säure zur Auslösung der Polymerisation des Pyrrols zum leitfähigen Polypyrrol im Bohrloch
6. Spülen mit Wasser
7. Galvanische Kupferabscheidung

Bei der praktischen Durchführung des Verfahrens zeigt es sich, daß das im Schritt 4 auf der Bohrloch-Wand und auf der Leiterplattenoberfläche aufgebrachte Pyrrol nicht nur dem Zweck jener Verfahren entsprechend an der Bohrlochwandung polymerisiert, um die leitfähige Beschichtung zu bilden, wenn es im Schritt 5 in das Säure enthaltende Bad getaucht wird, sondern auch in beträchtlicher Menge abgelöst wird und in einer Art "wilder Polymerisation" im Säurebad selbst polymerisiert. Hierdurch kommt es zur Bildung von Polypyrrolschlamm, der immer wieder aus Bad 5 entfernt werden muß.

Außerdem besteht die Gefahr, daß sich Pyrrol in Folge seines niedrigen Dampfdrucks in den Produktionsräumen verteilt und überall dort im Raume polymerisiert, wo sich Säure bzw. Säuredämpfe befinden.

Aus WO-A-91 08 324 ist ein Verfahren zur Herstellung von durchkontaktierten Leiterplatten bekannt, bei dem zunächst die Bohrlochwände mit 3,4-substituiertem Thiophen behandelt werden, wonach durch Säurebehandlung leitfähiges Polythiophen erzeugt und darauf schließlich das Metall galvanisch abgeschieden wird.

Die Aufgabe der Erfindung besteht darin, ein Verfahren zur Herstellung von durchkontaktierten Leiterplatten und Multilayern anzugeben, das die beschriebenen Nachteile vermeidet, insbesondere die Bildung von Polymerisaten, in den zur Behandlung erforderlichen Säurebändern.

Gegenstand der Erfindung ist ein Verfahren zur Herstellung von durchkontaktierten Leiterplatten und Multilayern, bei welchem an den Wänden der Bohrlöcher durch Behandeln mit einer Lösung oder Emulsion von 3,4-Ethylendioxythiophen und gleichzeitige oder anschließende Behandlung mit einer wäßrigen Säure eine leitfähige Schicht aus Poly-3,4-Ethylendioxythiophen erzeugt und auf dieser ein Metall galvanisch abgeschieden wird.

Ein besonderer Vorteil besteht darin, daß das Aufbringen des Thiophens und seine Polymerisation durch Säure in einem Behandlungsschritt zusammengefaßt werden können.

Man kann auch mit deutlich geringeren Monomerkonzentrationen als bei der Verwendung von Pyrrol auskommen.

Das erfindungsgemäße Verfahren erfordert somit folgende Schritte:
1. Herstellung der Bohrungen in den mit Kupfer kaschierten Platten (Basismaterialien)
2. Oxidative Vorbehandlung der Bohrlöcher, z.B. mit alkalischer Kaliumpermanganatlösung
3. Spülen mit Wasser
4. Behandlung mit einer Lösung oder Emulsion von 3,4-Ethylendioxythiophen
5. Behandlung mit einer wäßrigen Säure zur Auslösung der Polymerisation
6. Spülen mit Wasser
7. Galvanische Kupferabscheidung

Die Schritte 4 und 5 können durch Verwendung von Thiophen-Lösung beziehungsweise Emulsion und einer Säure zu einem Schritt zusammengefaßt werden. Diese Ausführungsform ist bevorzugt. Die Schritte 1, 2, 3, 6 und 7 entsprechen dem Stand der Technik und werden in an sich bekannter Weise durchgeführt. Bevorzugt wird in Schritt 2 Kaliumpermanganat als Oxidationsmittel verwendet.

Bei dem erfindungsgemäßen Schritt 4 werden Lösungen oder Emulsionen aus einem Monomeren des 3,4-Ethylendioxythiophens der Formel (I)

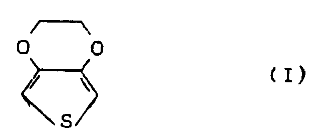

Die Monomeren der Formel (I) können in einer Konzentration von 0,1 bis 10 Gew.-%, bevorzugt 0,2 bis 5 Gew.-% und ganz besonders bevorzugt 0,5 bis 2,5 Gew.-%, bezogen auf die Gesamtlösung bzw. Emulsion im Verfahrensschritt 4 eingesetzt werden.

Als Säuren für Schritt 5 können organische oder anorganische Säuren verwendet werden.

Als organische Säuren seien z.B. genannt:
Aromatische Sulfonsäuren, wie p-Toluolsulfon-, Benzolsulfon-, Dodecylbenzolsulfonsäure, aliphatische Sulfonsäuren, wie Methansulfon-, Trifluormethansulfonsäure, aliphatische Carbonsäuren, wie Ameisen-, Essigsäure.

Als anorganische Säuren seien z.B. genannt: Schwefel-, Phosphor-, Salzsäure.

Als Säuren können weiterhin verwendet werden: Polymere organische Säuren, wie Polyacryl-, Polystyrolsulfon-, Polyvinylsulfonsäure oder Copolymere dieser Säuren mit anderen säuregruppenfreien Monomeren.

Die Säuren können in einer Konzentration von 0,1 bis 30 Gew.-%, bevorzugt 1 bis 10 Gew.-%, bezogen auf die Gesamtmenge der Lösung oder Emulsion bei Verfahrensschritt 4, eingesetzt werden.

Zur Verbesserung der Benetzbarkeit und im Falle von Emulsionen zur Erhöhung der Stabilität der Emulsionen können Tenside zugesetzt werden. Beispielhaft sind folgende Tenside aufgeführt: Polyether aus Oleylalkohol + 50 Mol Ethylenoxid, Polyether aus Oleylalkohol + 10 Mol Ethylenoxid, Polyester aus Rizinusöl + Ethylenoxid, Polyetherester aus Ölsäure + 6 Mol Ethylenoxid, Polyether aus Laurylalkohol + 5 Mol Ethylenoxid, Polyetherester aus Abietinsäure + 40 Mol Ethylenoxid, 3-Benzyl-4-hydroxy-biphenyl-polyglykolether, Glycerin-1,3-bis-(2-ethylhexyl-ether)-2-schwefelsäureeter, Na-Salz, Di-sek-butylnaphthalinsulfonat, Benzyl-dodecyl-dimethylammonium-chlorid, 2-Sulfobernsteinsäure-Na-Salzdiisooctylester.

Als Lösungsmittel oder Emulsionsmedium wird bevorzugt Wasser verwendet. Zur Verbesserung der Löslichkeit der Thiophene der Formel (I) können der Lösung bzw. Emulsion aus Säure und Thiophen der Formel mit Wasser mischbare organische Lösungsmittel zugesetzt werden.

Als geeignete organische Lösungsmittel seien genannt: Niedere Alkohole wie Methanol, Ethanol, Isopropanol, mehrwertige Alkohole, wie Glykol und Glycerin, aliphatische Ether wie Ethylglykol und Butylglykol, aliphatische Ketone wie Aceton und lineare oder cyclische Amide wie N,N-Dimethylformamid, N,N-Dimethylacetamid, N-Methylpyrrolidon.

Die organischen Lösungsmittel werden den erfindungsgemäßen Lösungen bzw. Emulsionen in einer Menge von 0 bis 100 Gew.-%, bevorzugt 0 bis 50 Gew.-% des gesamten Lösungsmitels zugesetzt.

Die Behandlung der Platten gemäß Verfahrensschritt 4 erfolgt bevorzugt bei Temperaturen von 0 bis 90°C, besonders bevorzugt bei 10 bis 50°C.

Die Behandlungsdauer liegt bevorzugt zwischen 1 Sekunde und mehreren Minuten, bevorzugt 5 Sekunden bis 2 Minuten.

Das erfindungsgemäße Verfahren zur Herstellung von durchkontaktierten zweilagigen Leiterplatten und Multilayern unter Verwendung von Poly-3,4-Ethylendioxythiophenen als leitfähige Ausrüstung der Bohrlöcher für die direkte galvanische Durchkontaktierung kann unter dem Einsatz aller bisher bekannten Leiterplattenbasismaterialien durchgeführt werden. Bevorzugt werden die folgenden kupferkaschierten Schichtpreßstoffe Phenolharz-Hartpapier, Epoxidharz-Hartpapier und Epoxidharz-Glashartgewebe eingesetzt werden, wobei mit den Epoxidharz-Glashartgeweben besonders gute Ergebnisse erzielt werden.

Die Durchkontaktierung kann in Behältern und Geräten erfolgen, die nach dem Stand der Technik üblicherweise eingesetzt werden können, wobei aber die Durchkontaktierung nach der Horizontaltechnik bevorzugt zum Einsatz gelangen sollte, insbesondere dann, wenn besonders dünne Bohrlöcher und solche mit einem ungünstigen Längen/Querschnitt-Verhältnis (wie z.B. bei Multilayern) durchkontaktiert werden sollen.

### Beispiele

### Beispiel 1

Eine beidseitig kupferkaschierte Leiterplatte aus glasfaserverstärktem Epoxidharz wird mit Bohrlöchern versehen. Die Platte wird dann 10 Minuten unter Bewegen in einer Lösung aus 2 g Kaliumpermanganat, 1 g Natronlauge und 100 ml Wasser bei 90°C gehalten. Anschließend wird die Platte mit Wasser gespült, bis das Wasser farblos abläuft. Die Platte wird dann in eine Emulsion aus 0,5 g 3,4-Ethylendioxythiophen, 2,0 g Polystyrolsulfonsäure (Molekulargewicht ca. 30 000), 0,2 g 2-Sulfobernsteinsäure-Na-Salz-Diisooctylester und 100 ml Wasser für 30 Sekunden getaucht. Anschließend wird die Platte unter fließendem Wasser gespült. Zur Verkupferung der Bohrlöcher wird die Platte an einem Galvanogestell befestigt und bei einer Spannung von 1,9 Volt in einem galvanischen Kupferbad, (®Cupracid 210 der Fa. Schering) 10 Minuten galvanisiert, um eine haftfeste und lückenlose Kupferbeschichtung zu ergeben.

### Beispiel 2

Eine kupferkaschierte Leiterplatte wird, wie in Beispiel 1 beschrieben, mit einer Kaliumpermanganatlösung vorbehandelt und mit Wasser gespült.

Die Platte wird dann in eine Emulsion aus 5,0 g 3,4-Ethylendioxythiophen, 15 g Polystyrolsulfonsäure-Natriumsalz (Molekulargewicht ca. 30 000), 5 g 98 %iger Schwefelsäure, 0,2 g 2-Sulfobernsteinsäure-Na-Salz-Diisooctylester als Tensid in 1 l Wasser für 30 Sekunden getaucht. Anschließend wird die Platte unter fließendem Wasser gespült und wie im Beispiel 1 beschrieben verkupfert. Diese Behandlung dauerte ca. 8 Minuten bis die Bohrlöcher lückenlos mit Kupfer beschichtet waren (Stromdichte 1 bis 10 A/dm²). Die so durchkontaktierte Leiterplatte wurde galvanisch mit einer Kupferschicht von 25 µm Dicke in den Bohrungen versehen. Der in der Leiterplattentechnik übliche Thermoschocktest wurde problemlos bestanden.

### Beispiel 3

Es wird wie im Beispiel 1 vorgegangen, wobei eine Emulsion aus 5,0 g 3,4-Ethylendioxythiophen, 10 g Polystyrolsulfonsäure, 10 g Polystyrolsulfonsäurenatriumsalz, 2,0 g 98 %ige Schwefelsäure, 2,0 g 3-Benzyl-4-hydroxy-biphenyl-polyglykolether und 1 l Wasser Verwendet wird. Nach der Verkupferung sind alle Bohrlöcher haftfest und lückenlos mit einer gleichmäßigen Kupferschicht versehen.

### Beispiel 4

Eine kupferkaschierte, gebohrte Leiterplatte wird, wie in Beispiel 1 beschrieben, mit einer Kaliumpermanganatlösung vorbehandelt und mit Wasser gespült.

Die Platte wird dann 1 Minute in eine 2%ige Lösung von 3,4-Ethylen-dioxythiophen in Isopropanol getaucht. Anschließend wird die Platte 1 Minute in eine 20%ige, wäßrige Schwefelsäure getaucht. Die Platte wird mit fließendem Wasser gespült und, wie in Beispiel 1 beschrieben, verkupfert. Während dieser Behandlung werden die Bohrlöcher vollständig mit Kupfer beschichtet.

### Beispiel 5

Eine beidseitig mit Kupfer kaschierte Leiterplatte aus Glasfaser-verstärktem Epoxidharz (FR-4 Qualität) wird mit Bohrlöchern versehen. Die Platte wird 10 Min. unter Bewegen in einer Lösung aus 2 g Kaliumpermanganat, 1 g Natronlauge und 100 ml Wasser bei 90°C behandelt und anschließend mit Wasser gespült, bis das Spülwasser farblos abläuft. Die Platte wird dann 2 Min. lang in eine Emulsion getaucht, die aus 1,5 g 3,4-Ethylendioxythiophen, 0,3 g 2-Sulfobernsteinsäure-Na-Salz-Diisooktylester und 100 ml Wasser hergestellt worden ist. Anschließend wird die Platte in einer 3%igen wäßrigen Lösung von Polystyrolsulfonsäure (Molekulargewicht ca. 30.000) 5 Min. lang behandelt und dann unter fließendem Wasser gespült. Zur Verkupferung der Bohrlöcher wird die Platte an einem Galvanogestell befestigt und bei einer Spannung von 1,9 V in einem käuflichen galvanischen Kupferbad 5 Min. lang galvanisiert, wobei sich in den Bohrlöchern eine haftfeste und lückenlose Kupferbeschichtung ergibt.

### Beispiel 6

Eine kupferkaschierte mit Bohrlöchern versehene Leiterplatte wird wie in Beispiel 1 beschrieben mit einer Kaliumpermanganatlösung vorbehandelt und mit Wassesr gespült.

Die Platte wird dann 1 Min. lang in eine 3%ige Lösung von 3,4-Ethylendioxythiophen in einem Gemisch aus 70 Gew.-Teilen Wasser und 30 Gew.-Teilen Butylglykol getaucht. Anschließend wird die Platte 1 Min. lang in einer ca. 3%igen wäßrigen Lösung von Polystyrolsäure getaucht. Die Platte wird mit fließendem Wasser gespült und wie in Beispiel 1 beschrieben verkupfert. Während dieser Behandlung werden die Bohrlöcher vollständig mit einer haftfesten Kupferschicht beschichtet.

### Beispiel 7

Eine kupferkaschierte, mit Bohrlöchern versehene Leiterplatte aus glasfaserverstärktem Epoxidharz wird 10 Minuten unter Bewegung mit einer Lösung aus 2 g Kaliumpermanganat, 1 g Natriumhydroxid in 100 ml Wasser bei 90°C behandelt und dann mit Wasser gewaschen, bis das ablaufende Wasser farblos ist.

Die Platte wird dann 20 Sekunden lang in eine Emulsion von 1,0 g 3,4-Ethylendioxythiophen, 2,0 g Polystyrolsulfonsäure (Molekulargewicht ca. 30 000) 1.0 g Polyetheroxisorbitanoleat und 100 ml Wasser eingetaucht und dann mit Wasser gewaschen.

Um die Löcher mit Kupfer zu beschichten, wird die Platte wie in Beispiel 1 beschrieben galvanisiert.

## Patentansprüche

1. Verfahren zur Herstellung von durchkontaktierten Leiterplatten und Multilayern, bei welchem an den Wänden der Bohrlöcher durch Behandlung mit einer Lösung oder Emulsion von 3,4-Ethylendioxythiophen und anschließende oder gleichzeitige Säurebehandlung eine leitfähige Schicht aus Poly-3,4-Ethylendioxythiophen erzeugt und auf dieser ein Metall galvanisch abgeschieden wird.

2. Verfahren nach Anspruch 1 umfassend folgende Verfahrensschritte:
1. Herstellung von Bohrungen in den mit Kupfer kaschierten Platten (Basismaterialien)
2. Oxidative Vorbehandlung der Bohrlöcher
3. Spülen mit Wasser
4. Behandlung mit einer Lösung oder Emulsion von 3,4-Ethylendioxythiophen
5. Behandlung mit einer Säure
6. Spülen mit Wasser
7. Galvanische Kupferabscheidung,

3. Verfahren nach Anspruch 3, dadurch gekennzeichnet, daß die Verfahrensschritte 4 und 5 zusammengefaßt werden.

## Claims

1. A process for the production of through-connected circuit boards and multilayers, in which a conductive layer of poly-3,4-ethylenedioxythiophene is produced on the walls of the holes by treatment with a solution or emulsion of 3,4-ethylenedioxythiophene and simultaneous or subsequent treatment with an acid and a metal is applied by electro-deposition to the conductive layer thus produced.

2. A process as claimed in claim 1 comprising the following steps:
1. formation of the holes in the copper-laminated boards (base materials)
2. oxidative pretreatment of the holes
3. rinsing with water
4. treatment with a solution or emulsion of 3,4-ethylene-dioxythiophene
5. treatment with an acid
6. rinsing with water
7. electrodeposition of copper.

3. A process as claimed in claim 2, characterized in that steps 4 and 5 are combined into a single step.

## Revendications

1. Procédé pour la préparation de plaques et de plaques multicouches de circuits imprimés à trous métallisés, pour lequel on produit sur les parois des trous percés une couche conductrice de poly(3,4-éthylènedioxythiophène) par traitement avec une solution ou une émulsion de 3,4-éthylènedioxythiophène et par traitement à l'acide subséquent ou simultané et qu'on dépose sur celle-ci un métal par galvanisation.

2. Procédé selon la revendication 1 comprenant les étapes de procédé suivantes :
1. Préparation de trous percés dans les plaques stratifiées de cuivre (matériaux de base).
2. Prétraitement de type oxydant des trous percés.
3. Rinçage à l'eau.
4. Traitement avec une solution ou une émulsion de 3,4-éthylènedioxythiophène.
5. Traitement avec un acide.
6. Rinçage à l'eau.
7. Dépôt galvanique de cuivre.

3. Procédé selon la revendication 2, caractérisé en ce qu'on peut réunir les étapes de procédé 4 et 5.
